# FASCICULE DE BREVET EUROPEEN

(11) **EP 3 850 659 B1**
(45) Date de publication et mention de la délivrance du brevet: **05.08.2026**
(21) Numéro de dépôt: 19779352.4
(22) Date de dépôt: 11.09.2019
(51) Int. Cl.: H10W 10/17

(54) **PROCEDE DE REALISATION D'UN SUBSTRAT AVANCÉ ET SUBSTRAT AVANCÉ**
VERFAHREN ZUR HERSTELLUNG EINES ERWEITERTEN SUBSTRATES UND ERWEITERTES SUBSTRAT
METHOD FOR MAKING AN ADVANCED SUBSTRATE AND ADVANCED SUBSTRATE

(30) Priorité: 14.09.2018 FR 1800972
(43) Date de publication de la demande: 21.07.2021
(73) Titulaire: SOITEC, 38190 Bernin (FR)
(72) Inventeur: SCHWARZENBACH, Walter, 38330 Saint Nazaire les Eymes (FR)
(74) Mandataire: IP Trust
(86) Numéro de dépôt international: PCT/EP2019/074276
(87) Numéro de publication internationale: WO 2020/053306

(56) Documents cités:
- US-A- 6 060 344
- US-A1- 2007 200 144
- US-A1- 2008 036 039

## Description

### DOMAINE DE L'INVENTION

La présente invention concerne le domaine de réalisation de composants semiconducteurs de type SOI (abréviation de Silicon on Insulator, ou Silicium sur Isolant), et notamment le domaine de réalisation de substrats avancés pour une intégration hybride de composants configurés pour des applications ou des fonctionnalités différentes.

### ETAT DE LA TECHNIQUE

Une structure SOI comporte, typiquement, une couche active en silicium, dans laquelle se trouvent les composants proprement dits, et sous laquelle est disposée une couche enterrée d'oxyde de silicium. Cette dernière constitue une isolation vis-à-vis des courants parasites et des charges provenant de particules ionisées. Elle permet également une bonne isolation de composants voisins réalisés dans la même couche de silicium, et notamment une diminution sensible des capacités parasites entre de tels composants voisins. Elle repose elle-même sur un substrat en silicium, qui joue le rôle de support mécanique.

Ce type de substrat est généralement réalisé par le procédé Smart Cut^{™} qui comprend les étapes suivantes :
- fourniture d'un substrat support,
- fourniture d'un substrat donneur en silicium monocristallin,
- formation d'une zone de fragilisation dans le substrat donneur, pour y délimiter la future couche active (la zone de fragilisation peut être formée par implantation d'espèces atomiques à une profondeur déterminée du substrat donneur),
- collage du premier substrat donneur sur le substrat support, après avoir formé une couche d'oxyde sur le substrat support ou sur le substrat donneur ou les deux, la couche d'oxyde étant destinée à former la couche d'oxyde enterré,
- détachement du premier substrat donneur le long de la zone de fragilisation, conduisant au transfert de la couche active sur le substrat support.
- réalisation d'un traitement de finition de la couche transférée, pour réparer ou retirer les défauts liés à l'étape de détachement et conférer à ladite couche les caractéristiques de rugosité et d'épaisseur optimales pour obtenir le substrat final de type SOI sur lequel les composants visés seront intégrés.

Le traitement de finition comporte de manière usuelle soit des traitements thermiques destinés à guérir les défauts issus du procédé d'implantation et de détachement, complétés par un polissage mécano-chimique destiné à améliorer la rugosité de la surface de la couche transférée tout en contribuant à amener son épaisseur à la valeur visée, soit des traitements thermiques destinés à amener l'épaisseur de la couche transférée à une épaisseur visée, complétés par des traitement thermiques additionnels réalisés à des températures élevées, typiquement supérieures à 1100 °C, destinés à lisser la surface de la couche active par diffusion thermo-activée des atomes de silicium

De manière générale, la couche active de silicium transférée a typiquement une épaisseur allant de quelques nanomètres à plusieurs centaines de nanomètres, tandis que la couche d'oxyde enterré a une épaisseur allant d'une dizaine de nanomètres à plusieurs centaines de nanomètres (typiquement 1000 nm) ou plus.

Les épaisseurs de la couche active et de la couche d'oxyde enterré, varient généralement en fonction de l'application visée. A titre d'exemple, l'épaisseur de la couche active en silicium est typiquement comprise entre environ 3 et 40 nm, et celle de la couche d'oxyde enterré est typiquement comprise entre environ 10 et 40 nm, pour les substrats destinés à la réalisation de composants SOI de type FD (Fully Depleted, ou complètement déserté). Par ailleurs, les substrats configurés pour la réalisation de composants SOI de type RF (Radio Frequency, ou radiofréquence), les épaisseurs de la couche active en silicium et de la couche d'oxyde enterré sont typiquement supérieures à environ 50 nm.

En effet, différentes épaisseurs de la couche d'oxyde de silicium enterré permettent d'obtenir des degrés d'isolation différents, des courants de fuite différents, des tenues en tension différentes, des capacités équivalentes différentes, autant de paramètres au choix du développeur. En outre, une ou plusieurs couches fonctionnelles peuvent être interposées entre la couche d'oxyde enterré et le substrat support en silicium. Ce type d'arrangement de couches a pour objectif de limiter l'auto-polarisation et les distorsions entre les composants, véhiculées par le substrat, notamment celles induites par le fort rayonnement électromagnétique de composants radiofréquences.

De ce fait, pour certaines applications ou fonctions, on préférera sélectionner plutôt des substrats de type SOI ayant une couche enterrée d'oxyde de silicium fine, par exemple pour réaliser des transistors de type FDSOI, pour d'autres applications on préférera des substrats de type SOI ayant une couche enterrée d'oxyde de silicium épaisse et/ou munis d'une couche additionnelle fonctionnelle pour réaliser, par exemple, des composants de puissance ou des composants radiofréquences.

Par ailleurs, du fait même des procédés de fabrication industriels connus de l'homme de l'art, l'immense majorité des substrats de type SOI sont « homogènes », autrement dit, les épaisseurs de la couche d'oxyde enterré et de la couche active sont constantes sur tout le substrat.

On connaît cependant des tentatives de réalisation de composants en alternant des zones de type "bulk" et de type SOI sur le même substrat.

L'article "Transistors on hybrid UTBB/Bulk substrates fabricated by local internai BOX dissolution" de P. Nguyen et al, et publié dans « Solid State Electronics, Vol. 90, pp 39-43, 2013 », décrit la réalisation de composants CMOS sur un substrat hybride SOI/massif obtenu par la technique de la dissolution interne et locale de la couche d'oxyde enterré. Cette technique souffre cependant, de deux problèmes majeurs pour une utilisation industrielle.

En effet, le procédé de dissolution engendre une transition mal contrôlée entre les portions de la couche d'oxyde enterré ayant des épaisseurs différentes. Les zones de transitions entre lesdites portions sont longues (de l'ordre de quelques pm au mieux, du fait du procédé de dissolution utilisé) et donc non compatibles avec une co-intégration à grande échelle.

De plus, pour une épaisseur de la couche d'oxyde dissoute de l'ordre d'une dizaine de nm, le procédé de dissolution génère une non-uniformité importante de la couche d'oxyde enterré et subséquemment de la couche active sur isolant. Cette non-uniformité est à l'origine d'une discontinuité du comportement électrique entre les zones ayant différentes épaisseurs de la couche d'oxyde enterré, ce qui est néfaste pour le bon fonctionnement des différents composants réalisés sur ce type de substrats hybrides. Le document US2007/200144 propose un procédé de fabrication d'un SOI avec une couche d'oxyde enterré patternée.

### EXPOSE DE L'INVENTION

Il existe actuellement un besoin de fournir un substrat « monolithique » de type SOI muni d'une couche électriquement isolante enterrée (ou une couche active) comportant au moins deux zones ayant différentes épaisseurs, tout en garantissant :
une uniformité des épaisseurs des différentes portions des couches,
une rugosité optimale, et
une transition abrupte entre les différentes portions des couches ayant différentes épaisseurs,
compatibles avec les spécifications d'une intégration à grande échelle de différents types de composants sur ledit substrat monolithique, comprenant par exemple des composants de type FDSOI.

Il existe également un besoin de fournir un procédé de réalisation de substrats ayant les spécifications citées ci-dessus, facile à mettre en oeuvre, et compatible avec des substrats donneurs et/ou receveurs spécifiques, par exemple comportant des couches de piégeage dites de type «Trap Rich » ou des couches dopées. En effet, ce type de substrats requiert des budgets thermiques de finition limités en particulier pour le lissage de la surface de la couche active sur isolant (procédés de type recuit rapide communément appelé « Rapid Thermal Annealing », par opposition aux procédés de type recuit groupé au four ou « Thermal Batch Annealing »).

Ces besoins sont de plus en plus importants, notamment dans le domaine des systèmes sur puce ou SOC (acronyme du terme anglo-saxon « System on Chip ») qui intègrent plusieurs fonctions sur une même puce, ou dans le domaine de la co-intégration de composants digitaux et de composants radiofréquences, ou encore dans le domaine des microsystèmes intégrant par exemple des capteurs ou des accéléromètres en compagnie de circuits de lecture.

On tend à satisfaire ces besoins tout en évitant les inconvénients précités, en prévoyant un procédé de réalisation d'un substrat avancé comportant les étapes suivantes :
a) Fournir un substrat receveur et un substrat donneur, ledit substrat donneur comportant :
   - Un substrat support ;
   - Une couche active en un matériau semi-conducteur monocristallin ; et
      Une couche sacrificielle en un matériau pouvant être gravé sélectivement par rapport à la couche active, la couche sacrificielle étant interposée entre le
   - substrat support et la couche active ;
      Une couche d'oxyde de silicium munie d'une surface libre et disposée de sorte que la couche active soit interposée entre la couche sacrificielle et la couche d'oxyde ;
b) Former une cavité dans la couche d'oxyde, la cavité présentant une ouverture affleurant la surface libre de sorte que la couche d'oxyde comporte une première portion ayant une première épaisseur e1 et disposée entre la cavité et la couche active , et une deuxième portion ayant une deuxième épaisseur e2 supérieure à la première épaisseur e1, la deuxième portion étant disposée entre la surface libre et la couche active ;
c) Former une couche de remplissage en silicium poly-cristallin de sorte à complètement remplir la cavité et former une deuxième surface libre continue et sensiblement plane, comportant au moins une première surface en silicium poly-cristallin ;
d) Assembler le substrat receveur et le substrat donneur au niveau de la deuxième surface libre ;
e) Eliminer le substrat support après l'étape d) en conservant la couche active et la couche sacrificielle.

Selon un mode de réalisation le procédé peut comporter une étape de gravure sélective de la couche sacrificielle tout en conservant la couche active, après l'étape e). Par ailleurs, l'étape d'assemblage d) peut comprendre une étape de collage par adhésion moléculaire.

Selon un mode de réalisation, le procédé peut comporter en outre les étapes suivantes :
b0) Former, avant l'étape b) et après l'étape a), une zone de fragilisation dans le substrat support, la zone de fragilisation étant sensiblement plane et située au voisinage de l'interface entre la couche sacrificielle et le substrat support ;
e0) Fracturer le substrat support selon la zone de fragilisation, après l'étape d).

De plus, la couche sacrificielle peut être en un matériau pouvant être gravé sélectivement par rapport au matériau du substrat support. De ce fait, le reste du substrat support disposé sur la couche sacrificielle, peut être gravé sélectivement après l'étape de fracture e0). La couche de remplissage peut également être formée par dépôt chimique en phase vapeur à une température comprise entre 150 °C et 250 °C.

Selon un mode de réalisation, la couche active en silicium monocristallin peut être réalisée par épitaxie. Par ailleurs, la couche active conservée après l'étape e), peut être localement amincie de sorte à réduire localement l'épaisseur de la couche active.

Selon un mode de réalisation, la couche de remplissage peut recouvrir la couche d'oxyde de silicium. En outre, une couche additionnelle en silicium poly-cristallin peut être formée au-dessus de la deuxième portion de la couche d'oxyde de silicium, ladite couche additionnelle ayant préférentiellement une épaisseur e' comprise entre 1 et 1000 nm, la deuxième surface libre formée à la suite de l'étape c) étant dans ce cas, entièrement en silicium poly-cristallin.

Par ailleurs, l'étape c) peut comporter l'amincissement de la couche de remplissage et/ou de la couche d'oxyde de sorte que la deuxième surface libre comporte en outre une deuxième surface en oxyde de silicium.

On prévoit également un substrat avancé comportant :
- Un substrat receveur ;
- Une couche active en matériau semi-conducteur monocristallin ; et
- Une couche électriquement isolante en oxyde de silicium interposée entre la couche active et le substrat receveur;
le substrat avancé comportant de plus une couche de silicium poly-cristallin disposée sur le substrat receveur, la couche de silicium poly-cristallin étant enrobée par la couche électriquement isolante de sorte à définir une première portion de la couche électriquement isolante ayant une première épaisseur e1 et interposée entre la couche de silicium poly-cristallin et la couche active, et une deuxième portion de la couche électriquement isolante ayant une deuxième épaisseur e2 supérieure à la première épaisseur e1, la deuxième portion étant disposée entre le substrat receveur et la couche active.

Selon un mode de réalisation, le substrat comporte une couche additionnelle en silicium poly-cristallin interposée entre, le substrat receveur et l'ensemble formé par la couche électriquement isolante et la couche de silicium poly-cristallin. Le substrat peut, en outre, comporter une couche électriquement isolante supplémentaire interposée entre la couche additionnelle et le substrat receveur. Préférentiellement, le substrat receveur comporte : une couche épitaxiée et dopée, configurée pour former des composants microélectroniques dans ladite couche épitaxiée. Par ailleurs, le substrat receveur peut comporter des circuits intégrés.

### BREVE DESCRIPTION DES FIGURES

D'autres caractéristiques et avantages de l'invention ressortiront de la description détaillée qui va suivre, en référence aux dessins annexés sur lesquels :
- les figures 1A à 1F, y compris 1D' et 1F', représentent des vues en coupe schématiques illustrant des étapes d'un procédé de réalisation d'un substrat avancé selon différents modes de mise en œuvre ; et
- les figures 2 à 4 représentent des vues en coupe schématiques de substrats avancés selon différents modes de réalisation.

Pour des raisons de lisibilité des figures, les différentes couches ne sont pas nécessairement représentées à l'échelle. Les signes de référence identiques d'une figure à l'autre désignent des éléments identiques ou remplissant la même fonction.

### DESCRIPTION DETAILLEE DE MODES DE REALISATION DE L'INVENTION

Pour les différents modes de mise en œuvre, les mêmes références seront utilisées pour des éléments identiques ou assurant la même fonction, par souci de simplification de la description.

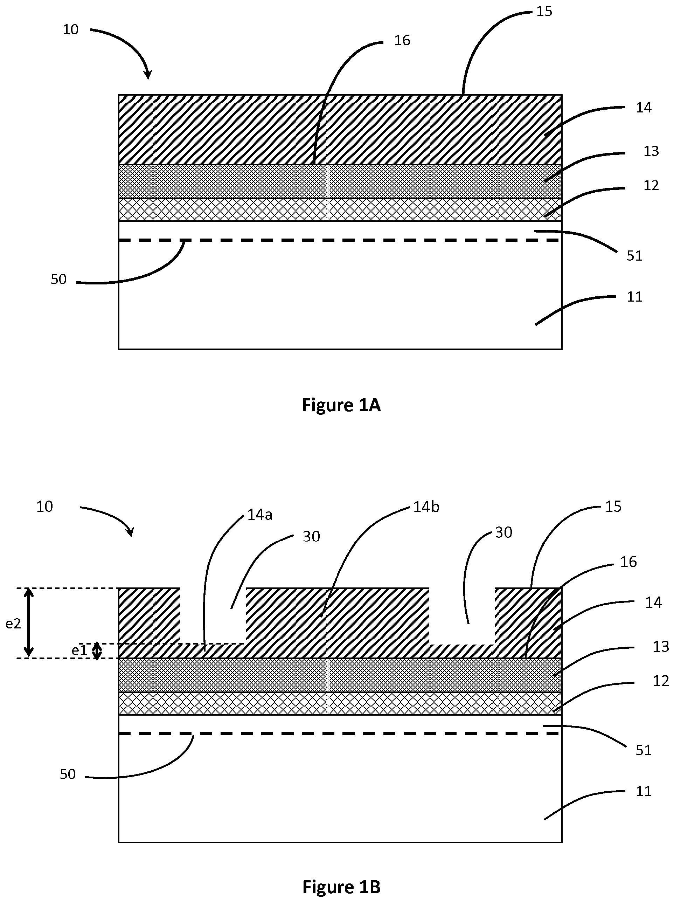

Les figures 1A à 1F représentent de manière schématique des modes de réalisation d'un procédé selon l'invention. Pour faciliter l'illustration, les épaisseurs respectives des différentes couches ne sont pas représentées à l'échelle.

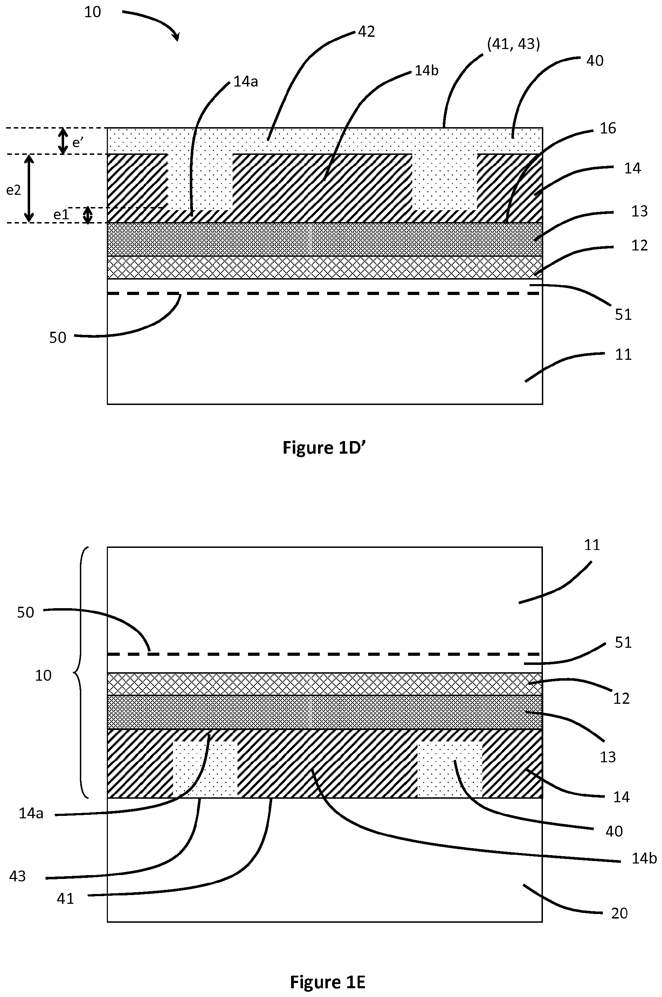

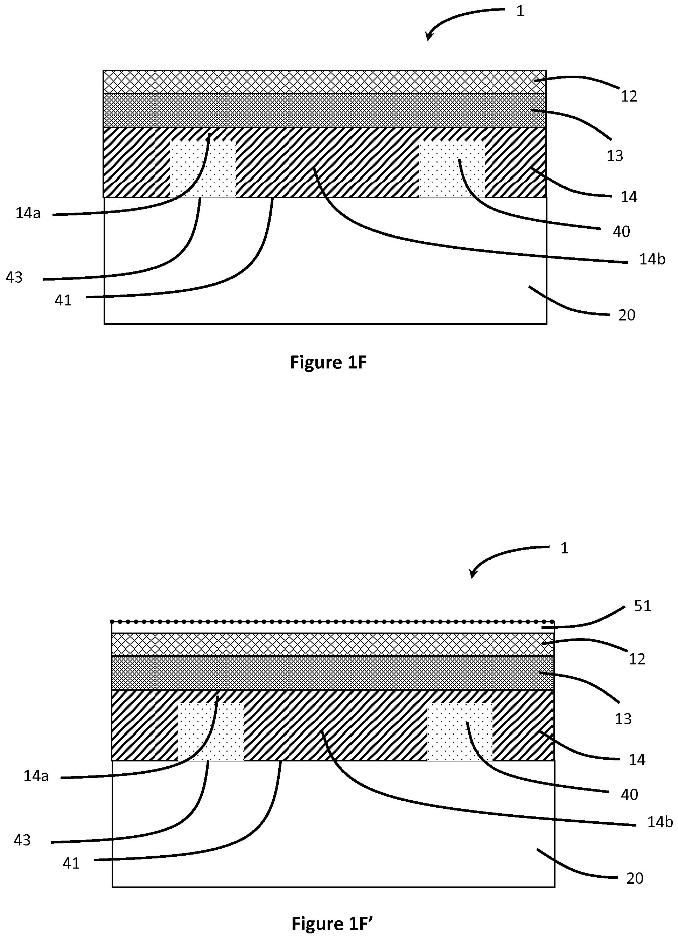

Selon un mode de réalisation le procédé de réalisation d'un substrat avancé 1 comporte une étape a) de fourniture d'un substrat receveur 20 (cf. les figures 1E, 1F et 1F'). Le substrat receveur 20 peut être en un matériau semi-conducteur ou en un autre matériau, selon qu'il doive assurer uniquement une fonction de support mécanique ou une fonction électrique au sein du substrat avancé 1 final. Préférentiellement, le substrat receveur 20 est à base de silicium. Par ailleurs, le substrat receveur 20 peut comporter une ou plusieurs couches additionnelles fonctionnelles telles qu'une couche de piégeage dite « Trap Rich », par exemple à base de silicium poly-cristallin (éventuellement avec une couche d'oxyde de silicium interposée entre le substrat 20 et la couche de piégeage), ou encore telles qu'une couche épitaxiée en matériau semi-conducteur dopée, etc.

Comme illustré à la figure 1A, cette étape comporte également une étape de fourniture d'un substrat donneur 10 comportant :
- Un substrat support 11 ;
- Une couche active 13 en un matériau semi-conducteur monocristallin ; et
- Une couche sacrificielle 12 en un matériau pouvant être gravé sélectivement par rapport à la couche active, la couche sacrificielle 12 étant interposée entre le substrat support 11 et la couche active 13 ;
- Une couche d'oxyde de silicium 14 munie d'une surface libre 15 et disposée de sorte que la couche active 13 soit interposée entre la couche sacrificielle 12 et la couche d'oxyde 14.

Le substrat support 11 peut être en un matériau semi-conducteur ou en un autre matériau, compte-tenu de la qualité cristalline escomptée des couches 12 et 13. Préférentiellement, le substrat support 11 est à base de silicium.

La couche active 13 est une couche configurée pour recevoir des composants microélectroniques. Autrement dit, lesdits composants seront formés dans la couche active 13. Préférentiellement, la couche active 13 est en silicium monocristallin, ou en silicium germanium monocristallin, pouvant être contraints ou relaxés.

Selon un mode de réalisation, la couche active 13 est avantageusement, formée par épitaxie. En effet, une couche formée par épitaxie permet d'obtenir une rugosité, une uniformité de l'épaisseur et un état de surface de la couche optimaux, notamment compatibles avec les spécifications des plus exigeants des procédés de réalisation de composants microélectroniques, tels que le procédé de réalisation de composants de type FDSOI.

Avantageusement, la couche sacrificielle 12 est également réalisée par épitaxie, pour faciliter une éventuelle épitaxie de la couche active 13. La couche sacrificielle peut être à base de silicium et de germanium, lorsque la couche active est à base de silicium, ou de silicium germanium. Par ailleurs, la couche 12 peut également être à base de n'importe quel matériau permettant une gravure sélective de la couche sacrificielle 12 par rapport à la couche active 13, du moment que sa qualité cristalline reste compatible avec celle exigée pour la couche active 13.

De manière encore plus avantageuse, les matériaux du substrat support 11 et de la couche sacrificielle 12 sont configurés de sorte que le matériau du support 11 se grave sélectivement par rapport à la couche sacrificielle 12, et de sorte que la couche sacrificielle 12 se grave sélectivement par rapport à la couche active 13.

La couche d'oxyde 14 peut être réalisée par n'importe quelle technique connue de l'homme du métier, et compatible avec des procédés conventionnels dans le domaine de la microélectronique. Préférentiellement, la couche d'oxyde 14 est un oxyde thermique usuel.

L'épaisseur du substrat support 11 peut être de l'ordre de quelques centaines de µm, typiquement 775 µm pour des substrats ayant un diamètre d'environ 300 mm. L'épaisseur de la couche sacrificielle 12 dépend de la technique et/ou de la solution de gravure utilisées. L'homme du métier saura adapter son épaisseur afin qu'elle puisse être gravée sélectivement, et de manière efficace, par rapport à la couche active 13. Avantageusement, son épaisseur est également adaptée pour que le matériau du substrat support 11 puisse être gravé sélectivement par rapport à la couche sacrificielle 12 tout en préservant les propriétés cristallines de la couche active 13.

L'épaisseur de la couche active 13 est préférentiellement comprise entre 5 et 500 nm, et l'épaisseur de la couche d'oxyde 14 est préférentiellement comprise entre 10 et 500 nm.

Comme illustré à la figure 1B, le procédé comporte une étape b) de formation d'au moins une cavité 30 dans la couche d'oxyde de silicium 14. La cavité 30 est débouchante, et comprend une ouverture affleurant la surface libre 15 de la couche d'oxyde 14. La cavité 30 comporte des parois. Les parois de la cavité 30 et l'ouverture de la cavité 30 délimitent le volume de la cavité 30. De manière avantageuse, la cavité 30 n'est pas traversante et ne comporte pas une ouverture affleurant l'interface entre la couche d'oxyde 14 et la couche active 13, de sorte que la couche d'oxyde 14 comporte une première portion 14a ayant une première épaisseur e1 non nulle. La première portion 14a est disposée entre la cavité 30 et la couche active 13.

La couche d'oxyde 14 comporte ainsi, une deuxième portion 14b ayant une deuxième épaisseur e2 supérieure à la première épaisseur e1 de la première portion 14a. La deuxième portion 14b est disposée entre la surface libre 15 et la couche active 13.

Dans un souci de simplification des figures, deux cavités 30 ont été représentées, mais il va de soi qu'un substrat donneur 10 peut comprendre en principe un grand nombre de cavités s'étendant parallèlement les unes aux autres. Préférentiellement, un réseau de cavités 30 est distribué dans la couche d'oxyde 14 de sorte à délimiter plusieurs motifs définissants les deuxièmes portions 14b. Autrement dit, chaque motif formant la deuxième portion 14b de la couche d'oxyde 14 est délimité par les cavités 30.

La cavité, ou le réseau de cavité 30 peut être réalisé par toute technique conventionnelle. Avantageusement, la cavité 30 peut être réalisée par une succession d'étapes de photolithographie et de gravure, connues et largement utilisées dans le domaine de la microélectronique. Ainsi, une transition abrupte entre les différentes portions des couches d'oxyde ayant différentes épaisseurs est avantageusement obtenue. Ce qui garantit également une uniformité des épaisseurs des couches, notamment des couches d'oxyde.

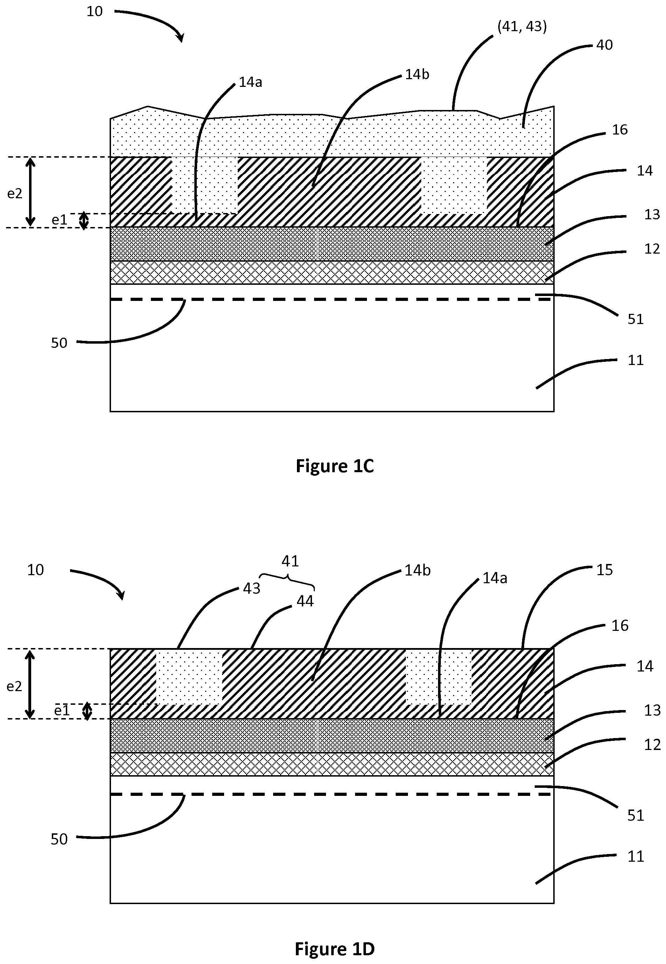

Après la formation de la cavité 30, le procédé comporte une étape c) destinée à former une couche de remplissage de la cavité 30. Comme illustré aux figures 1C, 1D et 1D', la couche de remplissage 40 est formée de sorte à complètement remplir la cavité 30 et former une deuxième surface libre 41 continue et sensiblement plane comportant au moins une première surface 43 à base du matériau de remplissage.

Selon un mode de réalisation, la couche de remplissage 40 recouvre la couche d'oxyde de silicium 14.

De manière avantageuse, la couche de remplissage 40 est en silicium poly-cristallin. Le silicium poly-cristallin est un matériau facile à déposer sur une couche en oxyde de silicium. En outre, ce matériau offre la possibilité d'un dépôt à basses températures, ce qui le rend compatible avec une structure comportant un substrat donneur épitaxié et/ou implanté. Enfin, le silicium poly-cristallin peut avantageusement servir à la fois de couche conductrice sous un futur oxyde enterré fin, défini par exemple dans la zone 14a, et de couche de piégeage (communément appelée couche de type « Trap Rich ») dans la zone 14b, tout en étant compatible avec un collage par adhésion moléculaire sur le substrat receveur 20.

En outre, il est connu que le silicium poly-cristallin possède une meilleure conductivité thermique qu'un oxyde de silicium. De ce fait, l'utilisation d'une couche enterrée à base d'oxyde de silicium comportant des couches en silicium poly-cristallin en combinaison avec un substrat receveur en silicium, permet avantageusement une meilleure dissipation de la chaleur, de la zone active vers et dans le substrat receveur.

Préférentiellement, l'étape c) comporte une étape de planarisation ou d'amincissement, configurée pour rendre la deuxième surface libre 41 sensiblement plane. L'étape de planarisation peut comporter des actions combinées de forces mécaniques et chimiques, telles qu'un procédé de polissage mécano-chimique, communément appelé procédé CMP.

Selon un mode de réalisation illustré à la figure 1D, l'étape c), notamment l'étape de planarisation, est mise en oeuvre de sorte à éliminer totalement le silicium poly-cristallin recouvrant la deuxième portion 14b de la couche d'oxyde 14. Autrement dit, l'étape c) comporte l'étape de planarisation ou d'amincissement de la couche 40 et/ou de la couche d'oxyde 14 de sorte que la deuxième surface libre 41 comporte en outre une deuxième surface 44 en oxyde de silicium.

Selon un autre mode de réalisation illustré à la figure 1D', une couche 42 en silicium poly-cristallin est formée au-dessus de la deuxième portion 14b de la couche d'oxyde de silicium 14 et de la cavité 30 remplie. Préférentiellement, la couche 42 a une épaisseur e' comprise entre 1 et 1000 nm. Selon ce mode de réalisation, la deuxième surface libre 41 formée à la suite de l'étape c) est entièrement en silicium poly-cristallin. La couche 42 peut être formée, par exemple, en adaptant successivement, l'épaisseur de la couche 40 formée, puis l'épaisseur éliminée de la couche 40, après l'étape de planarisation ou d'amincissement de la couche 40 en silicium poly-cristallin.

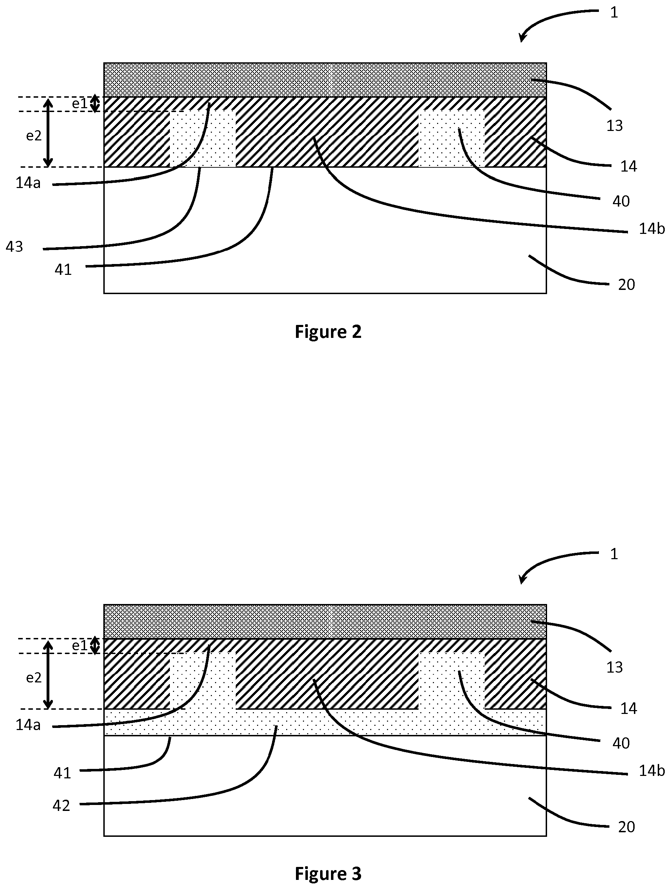

De ce fait, le substrat avancé 1 obtenu (cf. un exemple de substrat final obtenu, illustré à la figure 3), comportera avantageusement une couche d'isolant enterré comportant une couche 14b épaisse munie d'une couche fonctionnelle (couche de piégeage communément appelée couche de type « Trap Rich ») interposée entre le substrat receveur 20 et la couche d'isolation enterrée 14b, et une couche 14a d'oxyde fine. Ce type de substrat offrira une possibilité de co-intégration efficace de composants de type FDSOI disposés sur un isolant enterré fin (portion 14a), et des composants radiofréquences disposés sur un isolant enterré épais (portion 14b et une couche de silicium poly-cristallin) tout en limitant l'auto-polarisation et les distorsions entre les composants véhiculées par le substrat avancé 1, notamment celles induites par le fort rayonnement électromagnétique de composants radiofréquences. Ceci peut être possible, grâce à la couche fonctionnelle (couche 42) disposée « en-dessous » de la portion 14b en oxyde de silicium épais.

Par ailleurs, le procédé comporte en outre une étape d) d'assemblage du substrat receveur 20 et du substrat donneur 10 au niveau de la deuxième surface libre 41 (Cf. figure 1E). De manière avantageuse, l'étape d) d'assemblage est exécutée par adhésion moléculaire. L'assemblage est avantageusement exécuté par mise en contact direct de la deuxième surface libre 41 du substrat donneur 10 avec le substrat receveur 20.

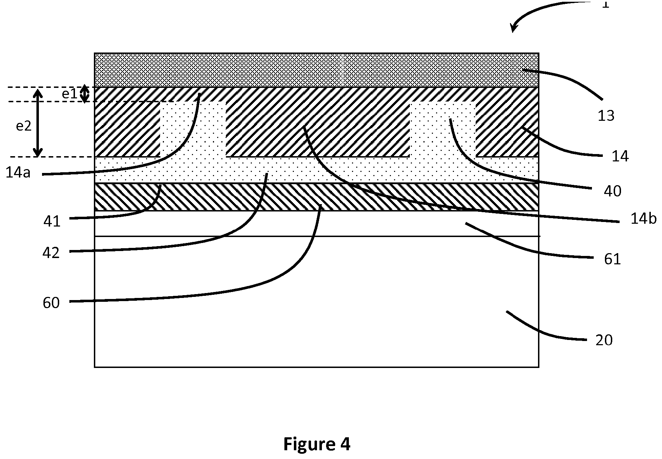

Dans un mode de réalisation, une couche électriquement isolante additionnelle, préférentiellement en oxyde de silicium, peut être formée sur le substrat donneur 10 et/ou sur le substrat receveur 20 avant l'étape d'assemblage. Avantageusement, ladite couche additionnelle est formée sur le substrat receveur 20, pour ne pas perturber la qualité des couches déjà réalisées sur le substrat donneur 10. Ladite couche additionnelle est ainsi interposée entre le substrat receveur 20 et le substrat donneur 10 (cf. par exemple le substrat final obtenu et illustré à la figure 4). Cette couche permet d'améliorer la qualité de l'assemblage par adhésion moléculaire, notamment si l'une des surfaces mises en contact comporte du silicium poly-cristallin. Le substrat ainsi formé s'apparentera et aura les avantages d'un double SOI. Il permettra également d'isoler électriquement le substrat receveur 20 des influences des potentiels appliqués dans la couche active 13, et dans la couche de remplissage 40. Il offre ainsi la possibilité pour le substrat receveur 20 de porter lui-même, des circuits intégrés ou une couche fonctionnelle (couche 61 de la figure 4). Par exemple, une couche semi-conductrice dopée, préférentiellement épitaxiée, permettant la co-intégration de composants additionnels sur substrat massif (substrat 20), tels que des mémoires intégrées (Embedded DRAM selon la terminologie anglo-saxonne).

Le procédé comporte en outre une étape e) d'élimination du substrat support 11 après l'étape d), en conservant la couche active 13 et la couche sacrificielle 120 pour obtenir le substrat avancé 1 (cf. figures 1F et 1F'). Cette élimination peut être réalisée par n'importe quelle technique conventionnelle connue de l'homme de métier et compatible avec les procédés utilisées dans le domaine de la microélectronique. A titre d'exemple, cette élimination peut être réalisée par abrasion ou encore par gravure chimique, ou de manière préférentielle par introduction d'une zone de fragilisation suivie d'une fracture.

Le procédé selon l'invention est facile à mettre en oeuvre et permet de manière avantageuse la formation d'un substrat « monolithique » muni d'une couche électriquement isolante enterrée comportant au moins deux zones ayant différentes épaisseurs, tout en garantissant une continuité du comportement électrique entre les zones ayant différentes épaisseurs de la couche d'oxyde enterré. En effet, grâce à la formation d'une cavité dans la couche d'oxyde qui a été remplie par du silicium poly-cristallin avant l'assemblage des substrats donneur et receveur, le substrat avancé obtenu bénéficie d'une uniformité des épaisseurs des différentes portions des couches, d'une rugosité optimale et une transition abrupte entre les différentes portions des couches ayant différentes épaisseurs. Ces caractéristiques rendent ainsi possible une intégration à grande échelle, optimisée pour la réalisation de composants de différents types sur un même substrat, notamment des dispositifs de type FDSOI et des dispositifs radiofréquences.

Selon un mode de réalisation, le procédé comporte une étape de gravure sélective de la couche sacrificielle 12 par rapport à la couche active 13, cette dernière étant conservée sur le substrat avancé final 1.

Les gravures sélectives sont préférentiellement des gravures chimiques humides. A titre d'exemple, la gravure sélective d'une couche de silicium par rapport à une couche sacrificielle de silicium germanium pourra être réalisée à l'aide d'une solution de TMAH. La gravure sélective d'une couche de silicium germanium par rapport à une couche de silicium pourra être réalisée à l'aide d'une solution d'acide acétique.

La gravure sélective permet avantageusement d'obtenir au final une couche active souhaitée dont l'épaisseur et la rugosité est équivalente à la performance d'un substrat épitaxié, ce qui ne pourrait être le cas si on mettait en œuvre un unique polissage mécanique ou mécano-chimique.

De manière avantageuse, l'étape de gravure sélective de la couche sacrificielle 12 par rapport à la couche active 13 est réalisée juste avant le procédé de réalisation des composants sur la couche active 13. En effet, la couche sacrificielle 12 peut jouer également le rôle d'une couche de passivation, évitant ainsi la formation d'une couche d'oxyde natif sur la couche active 13, et protégeant également cette dernière pendant la phase de stockage des substrats.

Selon un mode de réalisation le procédé comporte, en outre, les étapes suivantes (cf. les figures 1A à 1E) :
b0) Former, avant l'étape b) et après l'étape a), une zone de fragilisation 50 dans le substrat support 11, la zone de fragilisation 50 étant sensiblement plane et située au voisinage de l'interface entre la couche sacrificielle 12 et le substrat support 11 ;
e0) Fracturer le substrat support 11 selon la zone de fragilisation 50, après l'étape d), et préférentiellement, avant la gravure sélective de la couche sacrificielle 12, si elle est réalisée.

Autrement dit, l'élimination du substrat support 11 peut être réalisée par un détachement et une fracture de ce dernier. Ainsi, le substrat support n'est pas entièrement perdu et il peut avantageusement être réutilisé, notamment dans un nouveau cycle de réalisation d'un autre substrat avancé selon l'invention.

La zone de fragilisation 50 et l'interface entre la couche sacrificielle 12 et le substrat support 11 délimitent une couche résiduelle 51 destinée à être transférée sur la couche sacrificielle 12 après la fracture du substrat support 11.

Préférentiellement, les matériaux de la couche sacrificielle 12 et du substrat support sont choisis de sorte que la couche résiduelle puisse être gravée sélectivement par rapport à la couche sacrificielle 12. Comme illustré aux figures 1F et 1F', le procédé comporte, de manière avantageuse, une gravure sélective de la couche résiduelle 51 par rapport à la couche sacrificielle 12 après l'étape de fracture e0).

Avantageusement, la couche de remplissage 40 est formée par un dépôt chimique en phase vapeur à une température suffisamment basse pour pouvoir être réalisée sans impacter la zone de fragilisation 50. De manière préférentielle, la couche de remplissage 40 est formée par un dépôt chimique en phase vapeur à une température comprise entre 150 °C et 250 °C.

Selon un mode réalisation, la zone de fragilisation 50 peut être obtenue par implantation d'au moins un type d'espèces sélectionné dans le groupe suivant : Hydrogène, et Hélium. L'implantation de fragilisation peut être réalisée également avec plusieurs espèces implantées séquentiellement. Préférentiellement, le substrat support 11 est à base de silicium.

Les conditions de création de la couche de fragilisation 50 (espèces implantées, énergie et dose d'implantation) et de fracture dépendent des épaisseurs des couches 12 et 13. Par ailleurs, l'homme du métier saura ajuster ces conditions de sorte à former une zone de fragilisation 50 dans le substrat support 11. Par ailleurs, l'étape e0) de fracture est réalisée préférentiellement par un traitement thermique à une température pouvant être comprise entre 350 et 500 °C.

L'enchainement des étapes du procédé selon l'invention, permet de manière avantageuse, de former une zone de fragilisation avant la structuration de la couche d'oxyde enterré en formant une cavité puis en la remplissant avec un matériau semi-conducteur. Ainsi, une zone de fragilisation sensiblement plane peut être obtenue de manière facile et conventionnelle, facilitant ainsi la fracture et le détachement. En outre, le dépôt du matériau de remplissage peut être avantageusement réalisé à basses températures pour éviter une fracture prématurée et/ou une altération du substrat support avant l'assemblage des substrats donneur et receveur.

Bien que toutes les étapes du procédé selon l'invention puissent être réalisées à des températures ne dépassant pas 500 °C, on obtient avantageusement des couches uniformes ayant une rugosité de surface et des caractéristiques de surface optimales, notamment compatibles avec un procédé de réalisation de composants de type FDSOI. Le procédé selon l'invention permet en outre de se passer des étapes de finition à haute température et éviter avantageusement la recristallisation de la couche en silicium poly-cristallin. De ce fait, la couche de silicium poly-cristallin peut jouer le rôle d'une couche fonctionnelle, telle qu'une couche de piégeage (couche Trap Rich) au sein du substrat avancé final. Enfin, l'utilisation d'une gamme de températures aussi réduite permettrait, selon un mode particulier de réalisation de l'invention, le transfert du substrat donneur formé sur un substrat receveur « structuré », comprenant des dispositifs fonctionnels, dans le cadre d'un report de couches tridimensionnelles.

Selon un mode de réalisation, la couche active 13 conservée après l'étape e), est localement amincie de sorte à réduire localement l'épaisseur de la couche active 13. On obtient ainsi de manière avantageuse, un substrat avancé muni d'une couche active ayant des portions avec différentes épaisseurs et une couche d'oxyde enterré ayant également des portions avec différentes épaisseurs. Le substrat avancé peut ainsi être configuré pour réaliser, de manière efficace, des composants ayant différentes fonctionnalités.

Par ailleurs, on tend à satisfaire les besoins exposés préalablement tout en évitant les inconvénients précités, en prévoyant également un substrat avancé 1 comportant (cf. les figures 2 et 3):
- Un substrat receveur 20 ;
- Une couche active 13 en matériau semi-conducteur monocristallin ; et
- Une couche électriquement isolante 14 en oxyde de silicium interposée entre la couche active 13 et le substrat receveur 20.

Le substrat comporte en outre une couche de silicium poly-cristallin 40 disposée sur le substrat receveur 20. La couche de silicium poly-cristallin 40 est enrobée par la couche électriquement isolante 14 de sorte à définir une première portion 14a et une deuxième portion 14b, de la couche électriquement isolante 14. La première portion 14a a une première épaisseur e1 et elle est interposée entre la couche de silicium poly-cristallin 40 et la couche active 13. La deuxième portion 14b de la couche électriquement isolante 14 a une deuxième épaisseur e2 supérieure à la première épaisseur e1. La portion 14b est disposée entre le substrat receveur 20 et la couche active 13. Préférentiellement, la couche active 13 est surmontée d'une couche sacrificielle 12, pouvant être gravée sélectivement par rapport à la couche active 13, juste avant la réalisation des composants dans la couche active. Autrement dit, la couche sacrificielle joue en outre, le rôle d'une couche de protection du substrat avancé 1.

Selon un mode de réalisation illustré à la figure 3, le substrat avancé comporte une couche additionnelle 42 en silicium poly-cristallin interposée entre, le substrat receveur 20 et l'ensemble formé par la couche électriquement isolante 14 et la couche de silicium poly-cristallin 40.

Selon un autre mode de réalisation illustré à la figure 4, le substrat avancé 1 comporte, sous la couche 42, une seconde couche électriquement isolante 60, par exemple une couche d'oxyde de silicium disposée sur le substrat receveur 20. Le substrat receveur 20 peut lui-même comporter une couche fonctionnelle 61 telle qu'une couche épitaxiée dopée, ou encore comporter des dispositifs microélectroniques tels que des circuits intégrés, dans le cadre d'une approche 3D.

## Revendications

1. Procédé de réalisation d'un substrat avancé (1) comportant les étapes suivantes :
a) Fournir un substrat receveur (20) et un substrat donneur (10), ledit substrat donneur (10) comportant :
- Un substrat support (11) ;
- Une couche active (13) en un matériau semi-conducteur monocristallin ; et
- Une couche sacrificielle (12) en un matériau pouvant être gravé sélectivement par rapport à la couche active (12), la couche sacrificielle (12) étant interposée entre le substrat support (11) et la couche active (13) ;
- Une couche d'oxyde (14) de silicium, munie d'une surface libre (15) et disposée de sorte que la couche active (13) soit interposée entre la couche sacrificielle (12) et la couche d'oxyde (14) ;
b) Former une cavité (30) dans la couche d'oxyde (14), la cavité (30) présentant une ouverture affleurant la surface libre (15) de sorte que la couche d'oxyde (14) comporte une première portion (14a) ayant une première épaisseur (e1) et disposée entre la cavité (30) et la couche active (13), et une deuxième portion (14b) ayant une deuxième épaisseur (e2) supérieure à la première épaisseur (e1), la deuxième portion (14b) étant disposée entre la surface libre (15) et la couche active (13) ;
c) Former une couche de remplissage (40) en silicium poly-cristallin de sorte à complètement remplir la cavité (30) et former une deuxième surface libre (41) continue et sensiblement plane, comportant au moins une première surface (43) en silicium poly-cristallin ;
d) Assembler le substrat receveur (20) et le substrat donneur (10) au niveau de la deuxième surface libre (41) ;
e) Éliminer le substrat support (11) après l'étape d) en conservant la couche active (13) et la couche sacrificielle (12).

2. Procédé selon la revendication 1, comportant une étape de gravure sélective de la couche sacrificielle (12) tout en conservant la couche active (13), après l'étape e).

3. Procédé selon l'une des revendications précédentes, dans lequel l'étape d'assemblage d) comprend une étape de collage par adhésion moléculaire.

4. Procédé selon l'une des revendications précédentes, comportant les étapes suivantes :
b0) Former, avant l'étape b) et après l'étape a), une zone de fragilisation (50) dans le substrat support (11), la zone de fragilisation étant sensiblement plane et située au voisinage de l'interface entre la couche sacrificielle (12) et le substrat support (11) ;
e0) Fracturer le substrat support (11) selon la zone de fragilisation (50), après l'étape d).

5. Procédé selon la revendication 4, dans lequel le substrat support (11) est en un matériau pouvant être gravé sélectivement par rapport au matériau de la couche sacrificielle (12), le procédé comportant en outre une gravure sélective du reste du substrat support (11) disposé sur la couche sacrificielle (12) après l'étape de fracture e0).

6. Procédé selon l'une des revendications 4 ou 5, dans lequel la couche de remplissage
(40) est formée par dépôt chimique en phase vapeur à une température comprise entre 150°C et 250°C.

7. Procédé selon l'une des revendications précédentes dans lequel la couche active (13) en silicium monocristallin, est réalisée par épitaxie.

8. Procédé selon l'une des revendications précédentes, dans lequel la couche de remplissage (40) recouvre la couche d'oxyde de silicium (14).

9. Procédé selon la revendication 8, dans lequel une couche (42) en silicium poly-cristallin est formée au-dessus de la deuxième portion (14b) de la couche d'oxyde de silicium (14), la couche (42) ayant une épaisseur (e') comprise entre 1 et 1000 nm, la deuxième surface libre (41) formée à la suite de l'étape c) étant entièrement en silicium poly-cristallin.

10. Procédé selon l'une des revendications 1 à 8, dans lequel l'étape c) comporte l'amincissement de la couche de remplissage (40) et/ou de la couche d'oxyde (14) de sorte que la deuxième surface libre (41) comporte en outre une deuxième surface (44) en oxyde de silicium.

11. Procédé selon l'une des revendications précédentes, dans lequel la couche active (13) conservée après l'étape e), est localement amincie de sorte à réduire localement l'épaisseur de la couche active (13).

12. Substrat avancé (1) comportant :
- Un substrat receveur (20) ;
- Une couche active (13) en matériau semi-conducteur monocristallin ; et
- Une couche électriquement isolante (14) en oxyde de silicium interposée entre la couche active (13) et le substrat receveur (20);
le substrat avancé (1) comportant de plus une couche de silicium poly-cristallin (40) disposée sur le substrat receveur (20), la couche de silicium poly-cristallin (40) étant enrobée par la couche électriquement isolante (14) de sorte à définir une première portion (14a) de la couche électriquement isolante (14) ayant une première épaisseur (e1) et interposée entre la couche de silicium poly-cristallin (40) et la couche active (13), et une deuxième portion (14b) de la couche électriquement isolante (14) ayant une deuxième épaisseur (e2) supérieure à la première épaisseur (e1), la deuxième portion (14b) étant disposée entre le substrat receveur (20) et la couche active (13).

13. Substrat avancé (1) selon la revendication précédente, comportant une couche additionnelle (42) en silicium poly-cristallin interposée entre, le substrat receveur (20) et l'ensemble formé par la couche électriquement isolante (14) et la couche de silicium poly-cristallin (40).

14. Substrat avancé (1) selon la revendication précédente, comportant une couche électriquement isolante (60) supplémentaire interposée entre la couche additionnelle (42) et le substrat receveur (20).

15. Substrat avancé (1) selon la revendication précédente, où le substrat receveur (20) comporte une couche épitaxiée et dopée (61), configurée pour former des composants microélectroniques dans ladite couche épitaxiée (61).

16. Substrat avancé selon l'une des revendications 14 et 15, où le substrat receveur (20) comporte des circuits intégrés.

## Patentansprüche

1. Verfahren zur Herstellung eines fortschrittlichen Substrats (1), das die folgenden Schritte aufweist:
a) Bereitstellen eines Aufnahmesubstrats (20) und eines Donorsubstrats (10), wobei das Donorsubstrat (10) umfasst:
- ein Trägersubstrat (11)
- eine aktive Schicht (13) aus einem einkristallinen Halbleitermaterial; und
- eine Opferschicht (12) aus einem Material, das im Vergleich zur aktiven Schicht (12) selektiv geätzt werden kann, wobei die Opferschicht (12) zwischen dem Trägersubstrat (11) und der aktiven Schicht (13) angeordnet ist;
- eine Siliziumoxidschicht (14) mit einer freien Oberfläche (15), die so angeordnet ist, dass die aktive Schicht (13) zwischen der Opferschicht (12) und der Siliziumoxidschicht (14) liegt;
b) Ausbilden eines Hohlraums (30) in der Oxidschicht (14), wobei der Hohlraum (30) eine Öffnung aufweist, die bündig mit der freien Oberfläche (15) abschließt, sodass die Oxidschicht (14) einen ersten Abschnitt (14a) mit einer ersten Dicke (e1) aufweist, der zwischen dem Hohlraum (30) und der aktiven Schicht (13) angeordnet ist, und einen zweiten Abschnitt (14b) mit einer zweiten Dicke (e2) aufweist, die größer ist als die erste Dicke (e1), wobei der zweite Abschnitt (14b) zwischen der freien Oberfläche (15) und der aktiven Schicht (13) angeordnet ist
c) Bilden einer Füllschicht (40) aus polykristallinem Silizium, um den Hohlraum (30) vollständig auszufüllen und eine zweite durchgehende und im Wesentlichen ebene freie Oberfläche (41) zu bilden, die mindestens eine erste Oberfläche (43) aus polykristallinem Silizium aufweist;
d) Zusammenfügen des Aufnahmesubstrats (20) und des Donorsubstrats (10) an der zweiten freien Oberfläche (41) miteinander;
e) Entfernen des Trägersubstrats (11) nach Schritt d), wobei die aktive Schicht (13) und die Opferschicht (12) erhalten bleiben.

2. Verfahren nach Anspruch 1, das einen Schritt zum selektiven Ätzen der Opferschicht (12) unter Erhalt der aktiven Schicht (13) nach Schritt e) aufweist.

3. Verfahren nach einem der vorstehenden Ansprüche, wobei der Fügeschritt d) einen Schritt des Klebens durch molekulare Adhäsion aufweist.

4. Verfahren nach einem der vorstehenden Ansprüche, mit den folgenden Schritten:
b0) Bilden, vor Schritt b) und nach Schritt a) eines Schwächungsbereichs (50) im Trägersubstrat (11), wobei der Schwächungsbereich im Wesentlichen eben ist und sich in der Nähe der Grenzfläche zwischen der Opferschicht (12) und dem Trägersubstrat (11) befindet;
e0) Brechen des Trägersubstrats (11) entlang der Versprödungszone (50), nach Schritt d).

5. Verfahren nach Anspruch 4, wobei das Trägersubstrat (11) aus einem Material besteht, das im Vergleich zum Material der Opferschicht (12) selektiv geätzt werden kann, wobei das Verfahren weiter ein selektives Ätzen des auf der Opferschicht (12) befindlichen Rests des Trägersubstrats (11) nach dem Bruchschritt e0) aufweist.

6. Verfahren nach einem der Ansprüche 4 oder 5, wobei die Füllschicht (40) durch chemische Gasphasenabscheidung bei einer Temperatur zwischen 150 °C und 250 °C gebildet wird.

7. Verfahren nach einem der vorstehenden Ansprüche, wobei die aktive Schicht (13) aus monokristallinem Silizium durch Epitaxie hergestellt wird.

8. Verfahren nach einem der vorstehenden Ansprüche, wobei die Füllschicht (40) die Siliziumoxidschicht (14) bedeckt.

9. Verfahren nach Anspruch 8, wobei über dem zweiten Abschnitt (14b) der Siliziumoxidschicht (14) eine Schicht (42) aus polykristallinem Silizium gebildet wird, wobei die Schicht (42) eine Dicke (e') zwischen 1 und 1000 nm aufweist und die im Anschluss an Schritt c) gebildete zweite freie Oberfläche (41) vollständig aus polykristallinem Silizium besteht.

10. Verfahren nach einem der Ansprüche 1 bis 8, wobei der Schritt c) das Ausdünnen der Füllschicht (40) und/oder der Oxidschicht (14) aufweist, sodass die zweite freie Oberfläche (41) zusätzlich eine zweite Oberfläche (44) aus Siliziumoxid aufweist.

11. Verfahren nach einem der vorstehenden Ansprüche, wobei die nach Schritt e) verbleibende aktive Schicht (13) lokal verdünnt wird, um die Dicke der aktiven Schicht (13) lokal zu verringern.

12. Fortschrittliches Substrat (1), umfassend:
- ein Aufnahmesubstrat (20)
- eine aktive Schicht (13) aus einkristallinem Halbleitermaterial; und
- eine elektrisch isolierende Schicht (14) aus Siliziumoxid, die zwischen der aktiven Schicht (13) und dem Aufnahmesubstrat (20) angeordnet ist;
wobei das fortgeschrittene Substrat (1) weiter eine auf dem Aufnahmesubstrat (20) angeordnete Schicht aus polykristallinem Silizium (40) aufweist, wobei die polykristalline Siliziumschicht (40) von der elektrisch isolierenden Schicht (14) umhüllt ist, sodass ein erster Abschnitt (14a) der elektrisch isolierenden Schicht (14) mit einer ersten Dicke (e1) definiert wird, der zwischen der polykristallinen Siliziumschicht (40) und der aktiven Schicht (13) liegt, und
ein zweiter Abschnitt (14b) der elektrisch isolierenden Schicht (14) mit einer zweiten Dicke (e2), die größer ist als die erste Dicke (e1), wobei der zweite Abschnitt (14b) zwischen dem Aufnahmesubstrat (20) und der aktiven Schicht (13) angeordnet ist.

13. Fortgeschrittenes Substrat (1) nach dem vorstehenden Anspruch, mit einer zusätzlichen Schicht (42) aus polykristallinem Silizium, die zwischen dem Aufnahmesubstrat (20) und der aus der elektrisch isolierenden Schicht (14) und der Schicht aus polykristallinem Silizium (40) gebildeten Einheit angeordnet ist.

14. Fortgeschrittenes Substrat (1) nach dem vorstehenden Anspruch, die eine zusätzliche elektrisch isolierende Schicht (60) aufweist, die zwischen der zusätzlichen Schicht (42) und dem Aufnahmesubstrat (20) angeordnet ist.

15. Fortgeschrittenes Substrat (1) nach dem vorstehenden Anspruch, wobei das Aufnahmesubstrat (20) eine epitaktisch gewachsene und dotierte Schicht (61) aufweist, die dazu ausgelegt ist, mikroelektronische Bauelemente in der genannten epitaktisch gewachsenen Schicht (61) zu bilden.

16. Fortgeschrittenes Substrat nach einem der Ansprüche 14 und 15, wobei das Aufnahmesubstrat (20) integrierte Schaltungen aufweist.

## Claims

1. Method for making an advanced substrate (1) comprising the following steps:
a) Providing a receiver substrate (20) and a donor substrate (10), said donor substrate (10) comprising:
- A support substrate (11)
- An active layer (13) made of a monocrystalline semiconductor material; and
- A sacrificial layer (12) made of a material which can be selectively etched in relation to the active layer (12), the sacrificial layer (12) being interposed between the support substrate (11) and the active layer (13);
- A silicon oxide layer (14), provided with a free surface (15) and disposed such that the active layer (13) is interposed between the sacrificial layer (12) and the oxide layer (14);
b) Forming a cavity (30) in the oxide layer (14), the cavity (30) having an opening flush with the free surface (15) such that the oxide layer (14) comprises a first portion (14a) having a first thickness (e1) and disposed between the cavity (30) and the active layer (13), and
a second portion (14b) having a second thickness (e2) greater than the first thickness (e1), the second portion (14b) being disposed between the free surface (15) and the active layer (13)
c) Forming a filling layer (40) made of polycrystalline silicon so as to fill the cavity (30) completely and form a second continuous and substantially planar free surface (41), comprising at least a first surface (43) made of polycrystalline silicon;
d) Assembling the receiver substrate (20) and the donor substrate (10) at the second free surface (41);
e) Eliminating the support substrate (11) after step d) while preserving the active layer (13) and the sacrificial layer (12).

2. Method according to claim 1, comprising a step of selective etching of the sacrificial layer (12) while preserving the active layer (13), after step e).

3. Method according to one of the preceding claims, wherein the assembly step d) comprises a step of bonding by molecular adhesion.

4. Method according to one of the preceding claims, comprising the following steps:
b0) Forming, before step b) and after step a), an embrittlement zone (50) in the support substrate (11), the embrittlement zone being substantially planar and located in the vicinity of the interface between the sacrificial layer (12) and the support substrate (11);
e0) Fracturing the support substrate (11) along the embrittlement zone (50), after step d).

5. Method according to claim 4, wherein the support substrate (11) is made of a material which can be selectively etched in relation to the material of the sacrificial layer (12), the method further comprising selective etching of the remainder of the support substrate (11) disposed on the sacrificial layer (12) after the fracture step e0).

6. Method according to one of claims 4 or 5, wherein the filling layer (40) is formed by chemical vapour phase deposition at a temperature between 150°C and 250°C.

7. Method according to one of the preceding claims, wherein the active layer (13) made of monocrystalline silicon is made by epitaxy.

8. Method according to one of the preceding claims, wherein the filling layer (40) covers the silicon oxide layer (14).

9. Method according to claim 8, wherein a layer (42) made of polycrystalline silicon is formed above the second portion (14b) of the silicon oxide layer (14), the layer (42) having a thickness (e') between 1 and 1000 nm, the second free surface (41) formed following step c) being entirely made of polycrystalline silicon.

10. Method according to one of claims 1 to 8, wherein step c) comprises thinning the filling layer (40) and/or the oxide layer (14) such that the second free surface (41) further comprises a second surface (44) made of silicon oxide.

11. Method according to one of the preceding claims, wherein the active layer (13) preserved after step e), is locally thinned so as to reduce the thickness of the active layer (13) locally.

12. Advanced substrate (1) comprising:
- A receiver substrate (20)
- An active layer (13) made of monocrystalline semiconductor material; and
- An electrically-insulating layer (14) made of silicon oxide interposed between the active layer (13) and the receiver substrate (20);
the advanced substrate (1) further comprising a polycrystalline silicon layer (40) disposed on the receiver substrate (20), the polycrystalline silicon layer (40) being coated by the electrically-insulating layer (14) so as to define a first portion (14a) of the electrically-insulating layer (14) having a first thickness (e1) and interposed between the polycrystalline silicon layer (40) and the active layer (13), and
a second portion (14b) of the electrically-insulating layer (14) having a second thickness (e2) greater than the first thickness (e1), the second portion (14b) being disposed between the receiver substrate (20) and the active layer (13).

13. Advanced substrate (1) according to the preceding claim, comprising an additional layer (42) made of polycrystalline silicon interposed between, the receiver substrate (20) and the assembly formed by the electrically-insulating layer (14) and the polycrystalline silicon layer (40).

14. Advanced substrate (1) according to the preceding claim, comprising an additional electrically-insulating layer (60) interposed between the additional layer (42) and the receiver substrate (20).

15. Advanced substrate (1) according to the preceding claim, where the receiver substrate (20) comprises an epitaxial and doped layer (61), configured to form microelectronic components in said epitaxial layer (61).

16. Advanced substrate according to one of claims 14 and 15, where the receiver substrate (20) comprises integrated circuits.
